# EUROPEAN PATENT SPECIFICATION

(11) **EP 1 895 755 B1**
(45) Date of publication and mention of the grant of the patent: **02.01.2019**
(21) Application number: 07112622.1
(22) Date of filing: 17.07.2007
(51) Int. Cl.: H04N 1/00, G11C 17/18, G11C 17/16

(54) **Model-performance determining apparatus and image forming apparatus**
Vorrichtung zur Bestimmung einer Modell-Leistung und Bildgebungsvorrichtung
Appareil de détermination de modèle-performance et appareil de formation d'images

(30) Priority: 04.08.2006 JP 2006213811; 16.04.2007 JP 2007107388; 29.06.2007 JP 2007173167
(43) Date of publication of application: 05.03.2008
(73) Proprietor: Ricoh Company, Ltd., Tokyo 143-8555 (JP)
(72) Inventor: Kobayashi, Kazunori, Ricoh Company, Ltd., Tokyo 143-8555 (JP); Sekine, Kunio, Ricoh Company, Ltd., Tokyo 143-8555 (JP); Koya, Daisuke, Ricoh Company, Ltd., Tokyo 143-8555 (JP)
(74) Representative: Schwabe - Sandmair - Marx

(56) References cited:
- EP-A- 1 255 170
- JP-A- 2006 011 498
- US-A- 5 491 540
- US-A- 6 104 888
- US-A1- 2006 136 858
- US-A1- 2006 202 232
- US-B1- 6 215 966
- US-B2- 6 879 206

## Description

### CROSS-REFERENCE TO RELATED APPLICATIONS

The present application claims priority to Japanese priority documents, 2006-213811 filed in Japan on August 4, 2006, 2007-107388 filed in Japan on April 16, 2007 and 2007-173167 filed in Japan on June 29, 2007.

### BACKGROUND OF THE INVENTION

### 1. Field of the Invention

The present invention relates to a technology for causing a machine to function as a predetermined performance model based on model-specific information for setting a model.

### 2. Description of the Related Art

Recently, an inventory cost of an image forming apparatus, such as a digital copying machine, is increasing because various models of the image forming apparatus are commercialized. For suppressing the inventory cost, a system has been proposed, in which a model setting is not performed when the image forming apparatus is shipped from a manufacturing facility, leaving the model setting and determination of a destination at an intermediate sales point or a sales company.

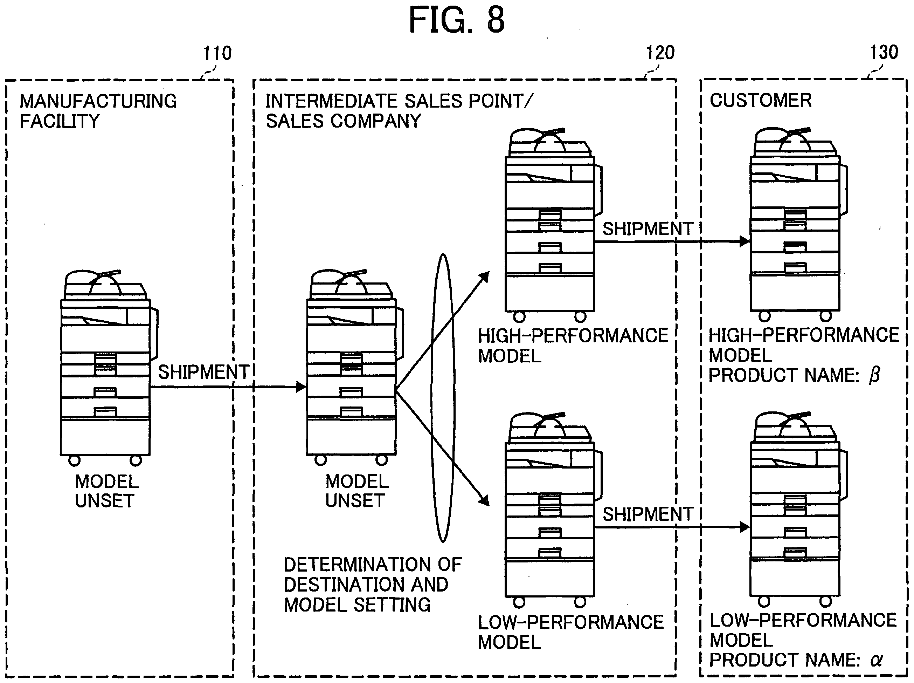

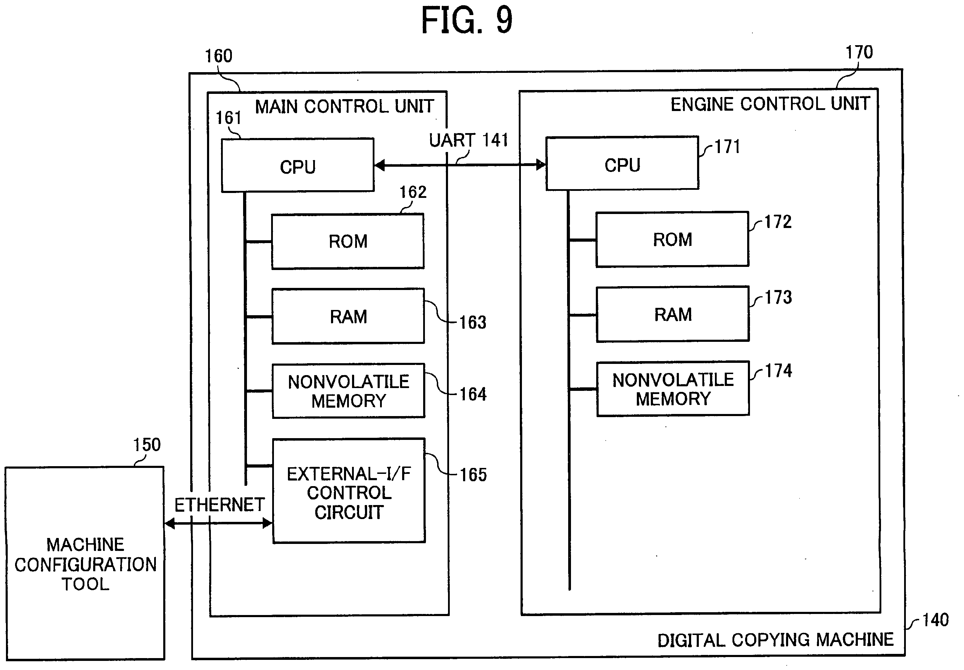

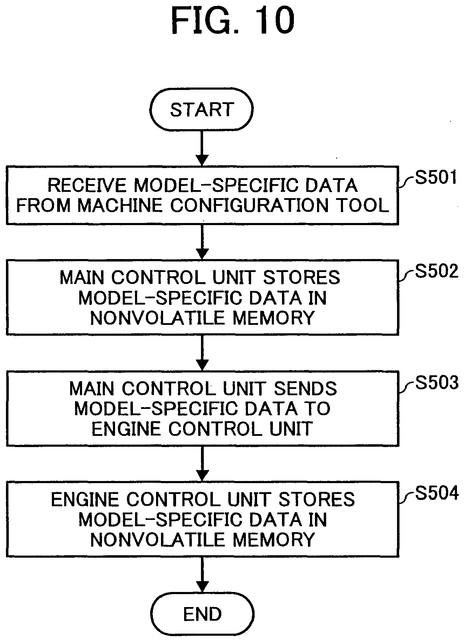

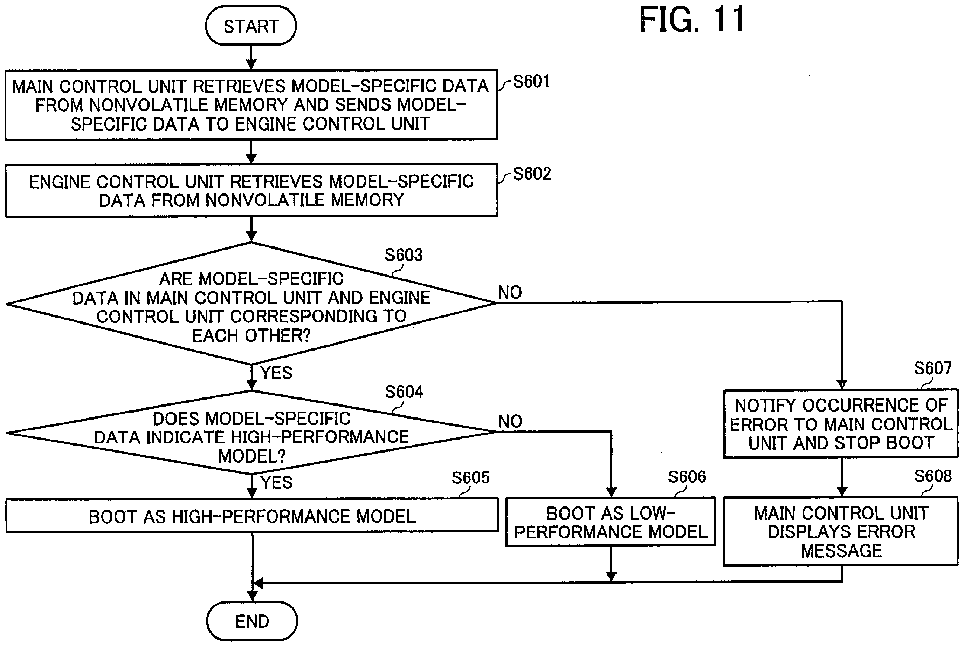

Fig. 8 is a schematic diagram for explaining a flow for setting a model performance of the image forming apparatus. Fig. 9 is a block diagram of a conventional model-performance determining apparatus. Fig. 10 is a flowchart for explaining an operation of setting the model performance with a conventional technology. Fig. 11 is a flowchart for explaining an operation performed after setting the model performance with the conventional technology. As shown in Fig. 8, if the model performance can be set at an intermediate sales point 120 (such as a sales company), multiple models are not necessary in a manufacturing facility 110 at the time of shipment. Accordingly, an inventory management can be simple and a required time taken from a placement of an order to the shipment of the image forming apparatus can be reduced.

Furthermore, inventories for each destination or model are not required in the intermediate sales point 120. Therefore, it is possible to avoid an unwanted inventory even when a certain model fails to achieve expected sales. In addition, it is possible to deal with an order in a timely manner.

For setting the model performance with a conventional technology, as shown in Fig. 8, a high-performance model described with a product name β and a low-performance model described with a product name α are provided to a customer 130. A machine is not determined to serve as the high-performance model or to serve as the low-performance model at the time of manufacturing and shipment from the manufacturing facility 110. The intermediate sales point 120 purchases a machine with the model unset, and thereafter, determines a destination and sets the model performance for a sales and a shipment to the customer 130 based on a sales prospect, sales data, or a requirement from the customer 130.

A configuration of a conventional model-performance determining apparatus is described with reference to Fig. 9. A central processing unit (CPU) 161 installed in a main control unit 160 in a digital copying machine 140 executes a control program built in a read only memory (ROM) 162, using a random access memory (RAM) 163 as a work area.

A CPU 171 is installed in an engine control unit 170 in the digital copying machine 140, and executes a control program built in a ROM 172, using a RAM 173 as a work area.

An operation mode or various engine data (a size of a sheet or a fixing status) set by a user is communicated between the main control unit 160 and the engine control unit 170 via a universal asynchronous receiver transmitter (UART) 141 to realize an operation of the digital copying machine 140.

Because a model performance of the digital copying machine 140 is not determined to be the high-performance model or the low-performance model at the time of the shipment from the manufacturing facility 110, a control program built in the ROM 162 of the main control unit 160 and a control program built in the ROM 172 of the engine control unit 170 are the same with each other when shipping the digital copying machine 140, and the control programs are not changed even after the digital copying machine 140 is provided to the customer 130.

In addition, model-specific data is not set in a nonvolatile memory 164 of the main control unit 160 and a nonvolatile memory 174 of the engine control unit 170.

When setting the model at the intermediate sales point 120, the model-specific data is set to the digital copying machine 140 using a machine configuration tool 150, such as a personal computer (PC).

As shown in Fig. 9, the machine configuration tool 150 is connected to an external-interface (I/F) control circuit 165 of the main control unit 160 via an Ethernet (registered trademark), and sends the model-specific data corresponding to a model to be set to the main control unit 160.

The CPU 161 of the main control unit 160 stores received model-specific data in the nonvolatile memory 164, and sends the model-specific data to the engine control unit 170 via the UART 141.

The CPU 171 of the engine control unit 170 stores the received model-specific data in the nonvolatile memory 174. At the customer site, the machine works as the high-performance model when two pieces of the model-specific data respectively stored in the nonvolatile memory 164 of the main control unit 160 and the nonvolatile memory 174 of the engine control unit 170 indicate a high-performance model. On the other hand, the machine works as the low-performance model when the two pieces of the model-specific data indicate a low-performance model. When the two pieces of the model-specific data do not indicate the same performance, it is determined that an error is occurring.

The model-specific data can be set based on a state of a dip switch, harness, or the like, instead of the model-specific data stored in the nonvolatile memory 174 of the engine control unit 170.

An operation of setting the model is described with reference to Figs. 9 and 10. Upon receiving the model-specific data from the machine configuration tool 150 (step S501), the main control unit 160 stores the model-specific data in the nonvolatile memory 164 (step S502). The main control unit 160 sends the model-specific data to the engine control unit 170 (step S503). The engine control unit 170 stores the model-specific data in the nonvolatile memory 174 (step S504).

An operation performed after setting the model is described with reference to Figs. 9 and 11. The main control unit 160 retrieves the model-specific data from the nonvolatile memory 164, and sends the model-specific data to the engine control unit 170 (step S601). The engine control unit 170 retrieves the model-specific data from the nonvolatile memory 174 (step S602), and determines whether two pieces of the model-specific data from the main control unit 160 and the engine control unit 170 indicated the same performance (step S603).

When it is determined that the two pieces of the model-specific data indicate the same performance at step S603, it is further determined whether the model-specific data indicate the high-performance model or the low-performance model (step S604). When it is determined that the model-specific data indicate the high-performance model, the digital copying machine 140 is booted as the high-performance model (step S605). On the other hand, when it is determined that the model-specific data indicate the low-performance model, the digital copying machine 140 is booted as the low-performance model (step S606). Subsequently, the process control ends.

When it is determined that the two pieces of the model-specific data do not indicate the same performance at step S603, an occurrence of an error is notified to the main control unit 160 and a boot is suspended (step S607). The main control unit 160 displays an error message on a display unit (not shown) to notify the occurrence of the error to a user.

However, although a model can be easily set in the manner described above, there is a possibility that a machine erroneously operates due to an erroneous model setting, or the machine is fraudulently modified due to a model setting performed for a malicious purpose. Thus, preventive measures are required for such problems.

Conventionally, various technologies for setting models have been proposed. For example, Japanese Patent Application Laid-Open No. 2006-11498 discloses a technology for determining a model by writing, by a model-determination control unit, model-dependent data in one of storing units provided in a plurality of areas inside a machine, so that the model can be determined at a startup of the machine by retrieving the model-dependent data. With the above conventional technology, it is difficult for a person, except for a manufacturer of the machine, to find an area in which the model-dependent data is stored. As a result, the machine can hardly be modified for a malicious purpose.

The model-dependent data according to the above document is used for determining the model, and is necessary for each hardware to work as a predetermined model. For example, when the machine is an image forming apparatus, data on a sheet feeding speed, a charging potential, a sheet feeding interval, or the like can be the model-dependent data.

However, with the conventional technology, it is problematic that costs for a machine increase because the conventional technology is based on an assumption that plural memories are installed in the machine.

Furthermore, the same model-dependent data can be easily generated by dumping contents of a memory because it is easy for a user to assume that the model-dependent data is stored in the memory. In this case, it is difficult to prevent a fraudulent modification.

Moreover, a configuration employed in the conventional technology is such that an operation of the machine is determined exclusively by retrieving the predetermined model-dependent data, and the machine does not include a function for setting the model-dependent data by itself. Therefore, when the model-dependent data corresponding to the high-performance model is fraudulently copied or extracted by a malicious person from a different image forming apparatus in the same model as that of a target image forming apparatus, because the model-dependent data can be easily replicated, the target image forming apparatus may fraudulently modified from the low-performance model to the high-performance model. Thus, it is problematic that a security is hardly assured.

US Patent 6,879,206 B2 discloses a disabler circuit for disabling a function of a device. The function is disabled by blowing a fuse and storing information about the state of the fuse. In operation, the state of the fuse is determined and compared to the information that is stored. If those two information are different, the fuse is blown again.

### SUMMARY OF THE INVENTION

It is an object of the present invention to at least partially solve the problems in the conventional technology.

An apparatus according to one aspect of the present invention is for determining a model performance of a target machine for which the model performance is to be set. The apparatus includes a first storing unit that stores therein first model-specific data defining a performance of the target machine; a generating unit that generates second model-specific data defining the performance of the target machine based on the first model-specific data; a second storing unit that stores therein the second model-specific data; an irreversible unit that realizes an irreversible state in which a transition is possible from a second state to a first state, while a transition is not possible from the first state to the second state; a comparing unit that compares the first model-specific data with the second compares the first model-specific data with the second model-specific data; a setting unit that sets a state of the irreversible unit based on a result of comparison by the comparing unit; and a performance determining unit that determines the performance of the target machine based on the first model-specific data, the second model-specific data, and the state of the irreversible unit.

An image forming apparatus according to another aspect of the present invention includes a model-performance determining apparatus that determines a model performance of a target machine for which the model performance is to be set. The model-performance determining apparatus includes a first storing unit that stores therein first model-specific data defining a performance of the target machine, a generating unit that generates second model-specific data defining the performance of the target machine based on the first model-specific data, a second storing unit that stores therein the second model-specific data, an irreversible unit that realizes an irreversible state in which a transition is possible from a second state to a first state, while a transition is not possible from the first state to the second state, a comparing unit that compares the first model-specific data with the second model-specific data, a setting unit that sets a state of the irreversible unit based on a result of comparison by the comparing unit, and a performance determining unit that determines the performance of the target machine based on the first model-specific data, the second model-specific data, and the state of the irreversible unit.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

Fig. 1 is a block diagram of a digital copying machine according to an embodiment of the present invention;
Fig. 2 is a block diagram of a configuration unit in a model-performance determining apparatus according to the embodiment;
Fig. 3 is a table of an example of combinations of three pieces of model-specific data, with which an operation is performed by a digital copying machine according to a first embodiment of the present invention;
Fig. 4 is a flowchart for explaining an operation performed, when setting a model, by the digital copying machine according to the first embodiment;
Fig. 5 is a flowchart for explaining an operation performed, after setting the model, by the digital copying machine according to the first embodiment;
Fig. 6 is a flowchart for explaining an operation performed, after setting a model, by a digital copying machine according to a second embodiment of the present invention;
Fig. 7 is a flowchart for explaining an operation performed, after setting a model, by a digital copying machine according to a fifth embodiment of the present invention;
Fig. 8 is a schematic diagram for explaining a flow of setting a model performance of an image forming apparatus according to the embodiment;
Fig. 9 is a block diagram of a conventional model-performance determining apparatus;
Fig. 10 is a flowchart for explaining an operation of setting a model performance with a conventional technology; and
Fig. 11 is a flowchart for explaining an operation performed after setting the model performance with the conventional technology.

### DETAILED DESCRIPTION OF THE PREFERRED EMBODIMENTS

Exemplary embodiments of the present invention are explained in detail below with reference to the accompanying drawings. Although an image forming apparatus, such as a digital copying machine, is described as an example of an electronic apparatus according to the embodiments, other electronic apparatuses can be applicable.

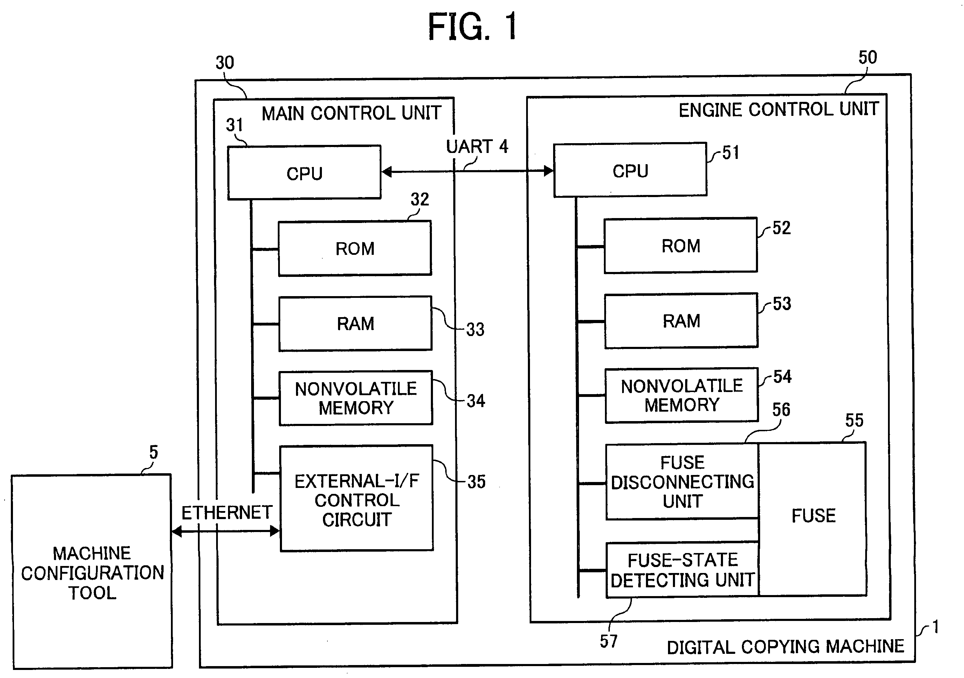

Fig. 1 is a block diagram of a digital copying machine 1 according to embodiments of the present invention. A main control unit 30 of the digital copying machine 1 includes a central processing unit (CPU) 31, a read only memory (ROM) 32, a random access memory (RAM) 33, a nonvolatile memory 34 as a first storing unit, and an external-I/F control circuit 35.

An engine control unit 50 of the digital copying machine 1 includes a CPU 51, which is used as a generating unit, a comparing unit, and a performance determining unit, a ROM 52, a RAM 53, a nonvolatile memory 54 as a second storing unit, a fuse 55 as an irreversible unit, a fuse disconnecting unit 56, which is used as a setting unit, a performance maintaining unit, and a disconnecting unit, and a fuse-state detecting unit 57 as a checking unit for checking a fuse state.

The main control unit 30 and the engine control unit 50 are connected with each other via a UART 4. The external-I/F control circuit 35 is connected to a machine configuration tool 5 via a communication line, such as the Ethernet.

The CPU 31 included in the main control unit 30 executes a control program built in the ROM 32, using the RAM 33 as a work area.

The ROM 32 stores therein a control program, data, or the like. In an example described in connection with Fig. 8, the digital copying machine 1 is not determined to be a high-performance model or a low-performance model at a time of shipment from the manufacturing facility 110. Accordingly, a control program is uniform and not changed after the digital copying machine 1 is provided to the customer 130.

The RAM 33 temporarily stores therein data or the like. For example, the RAM 33 temporarily stores therein data, as a work area of the CPU 31.

The nonvolatile memory 34 is a device that keeps contents stored therein even after power of the digital copying machine 1 is turned OFF, and is constituted of a nonvolatile semiconductor memory. For example, the nonvolatile memory 34 stores therein model performance of the digital copying machine 1, i.e., model-specific data for determining whether to be the high-performance model or the low-performance model. The model-specific data is unset at a time of the shipment from the manufacturing facility 110 because a model setting operation has not been performed.

The external-I/F control circuit 35 is an I/F control unit connected to the machine configuration tool 5 via a local area network (LAN), such as the Ethernet. For example, the external-I/F control circuit 35 receives the model-specific data of the digital copying machine 1 from a personal computer (PC) serving as the machine configuration tool 5.

The engine control unit 50 includes the CPU 51 and executes a control program built in the ROM 52, using the RAM 53 as a work area.

The ROM 52 stores therein a control program, data, or the like. In an example described in connection with Fig. 8, the digital copying machine 1 is not determined to be the high-performance model or the low-performance model at a time of the shipment from the manufacturing facility 110. Accordingly, a control program is uniform and not changed even after the digital copying machine 1 is provided to the customer 130.

The RAM 53 temporarily stores therein data or the like. For example, the RAM 53 temporarily stores therein data, as a work area of the CPU 51.

The nonvolatile memory 54 is a device that keeps contents stored therein even after power of the digital copying machine 1 is turned OFF. For example, the nonvolatile memory 54 stores therein the model-specific data of the digital copying machine 1. The model-specific data is unset at a time of the shipment from the manufacturing facility 110 because the model setting operation has not been performed.

The fuse 55 is an electrical circuit element having irreversibility, with which the fuse 55 can make a transition from a connected state (a second state) to a disconnected state (a first state) by a blowout (cut down) using Joule heat, while the fuse 55 cannot make a transition from the disconnected state (the first state) to the connected state (the second state). The CPU 51 controls whether to disconnect the fuse 55 by the fuse disconnecting unit 56, based on the first and the second model-specific data set in each of the nonvolatile memory 34 of the main control unit 30 and the nonvolatile memory 54 of the engine control unit 50, at the time of a model setting. For example, the fuse 55 is not disconnected when the digital copying machine 1 serves as the high-performance model, while the fuse 55 is disconnected when the digital copying machine 1 serves as the low-performance model. A state of the fuse 55 can be checked by the fuse-state detecting unit 57.

The UART 4 is a communication circuit that communicates operation mode, user setting, various engine data (a sheet size and a fixing status), or the like between the main control unit 30 and the engine control unit 50.

The machine configuration tool 5 sends data, such as the model-specific data, necessary for a machine configuration to the digital copying machine 1. For example, a PC can serve as the machine configuration tool 5.

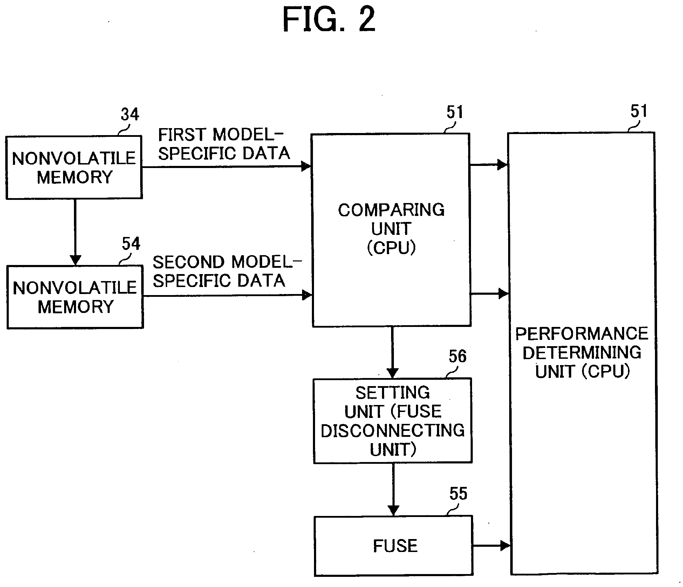

Fig. 2 is a block diagram of a configuration unit in a model-performance determining apparatus according to the embodiment. The first model-specific data for determining the performance of the digital copying machine 1 is written from the machine configuration tool 5 to the nonvolatile memory 34 of the main control unit 30. The second model-specific data, which is generated by the CPU 51 of the engine control unit 50 based on the first model-specific data and which is used for determining the performance of the digital copying machine 1, is written to the nonvolatile memory 54 of the engine control unit 50. The CPU 51 serving as the comparing unit in the engine control unit 50 compares the first model-specific data with the second model-specific data. The fuse disconnecting unit 56 serving as the setting unit sets the state of the fuse 55 to be disconnected or connected based on a comparison result. The CPU 51 serving as the performance determining unit in the engine control unit 50 determines the model performance of the digital copying machine 1 based on the state of the fuse 55, the first model-specific data, and the second model-specific data.

The digital copying machine 1 configured as described above stores the model-specific data in the nonvolatile memory 34 of the main control unit 30 and the nonvolatile memory 54 of the engine control unit 50, upon receiving the model-specific data from the machine configuration tool 5 as an external device. In addition, the digital copying machine 1 includes the fuse 55 as the electrical circuit element of which state can be changed in an irreversible manner.

Although the main control unit 30 and the engine control unit 50 are connected via the UART 4, a communication circuit is not thus limited and other communication circuits can be applicable.

The digital copying machine 1 including a model-performance determining device of the present invention is described in a first embodiment of the present invention. At the time of the shipment from the manufacturing facility, the digital copying machine 1 is not determined to be the high-performance model or the low-performance model (see Fig. 8). Accordingly, the control programs built in each of the ROM 32 of the main control unit 30 and the ROM 52 of the engine control unit 50 indicate the same performance, and not changed even after the digital copying machine 1 is provided to the customer 130.

The model-specific data is not set in each of the nonvolatile memory 34 of the main control unit 30 and the nonvolatile memory 54 of the engine control unit 50. The fuse 55 is in a connected state, in which a high-performance model is set or a model setting is not performed.

When a model is set in the intermediate sales point 120 as shown in Fig. 8, the model-specific data is set to the digital copying machine 1 using the machine configuration tool 5 constituted of a PC or the like. The machine configuration tool 5 is connected to the external-I/F control circuit 35 of the main control unit 30 via the Ethernet, so that the machine configuration tool 5 sends the model-specific data corresponding to a model to be set to the main control unit 30.

The CPU 31 of the main control unit 30 stores the model-specific data received from the machine configuration tool 5 in the nonvolatile memory 34, and sends the model-specific data to the engine control unit 50 via the UART 4.

The CPU 51 of the engine control unit 50 stores received model-specific data in the nonvolatile memory 54. The CPU 51 of the engine control unit 50 determines whether the digital copying machine 1 serves as the high-performance model or the low-performance model, based on the model-specific data stored in each of the nonvolatile memory 34 of the main control unit 30 and the nonvolatile memory 54 of the engine control unit 50. When the digital copying machine 1 is determined to serve as the high-performance model, the fuse 55 is kept in the connected state without operating the fuse disconnecting unit 56. On the other hand, when the digital copying machine 1 is determined to serve as the low-performance model, the fuse disconnecting unit 56 is caused to set the fuse 55 to be in the low-performance mode by disconnecting the fuse 55.

After the model is set, the digital copying machine 1 determines its operations at a site of the customer 130, based on the model-specific data set and stored in each of the nonvolatile memory 34 of the main control unit 30, the nonvolatile memory 54 of the engine control unit 50, and the fuse 55.

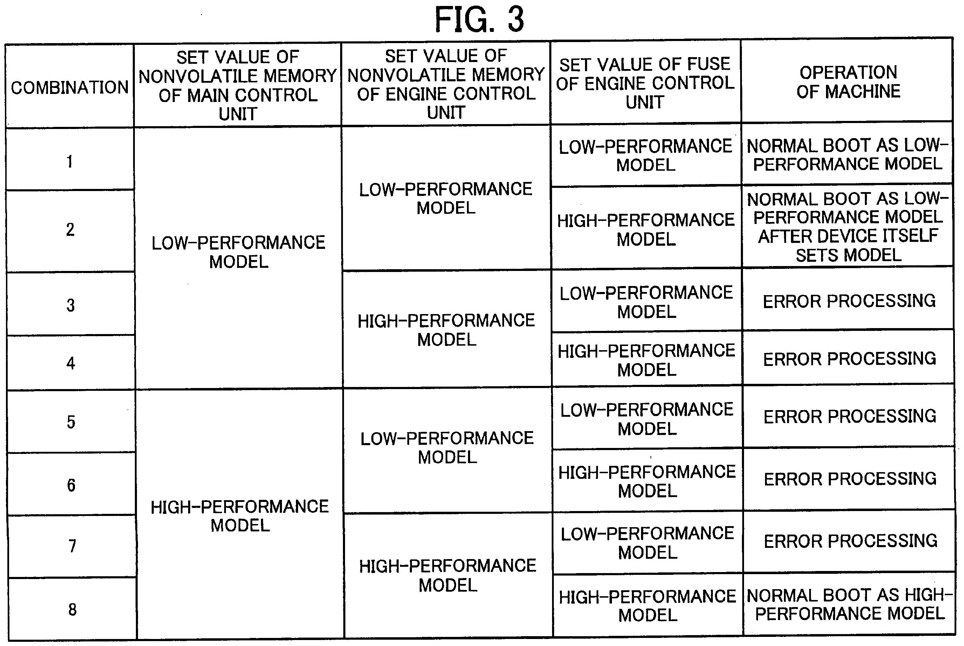

Fig. 3 is a table of an example of combinations of three pieces of model-specific data, with which the digital copying machine 1 performs an operation. As shown in Fig. 3, when all pieces of the model-specific data indicate the high-performance model, the digital copying machine 1 serves as the high-performance model (combination 8). When all pieces of the model-specific data indicate the low-performance model, the digital copying machine 1 serves as the low-performance model (combination 1). When all pieces of the model-specific data do not indicate the same performance, the digital copying machine 1 is able to determine an operation performed in a commercial market based on a combination of the operations.

For example, when settings in each of the nonvolatile memory 34 of the main control unit 30 and the nonvolatile memory 54 of the engine control unit 50 indicate the low-performance model, while a setting in the fuse 55 indicates the high-performance model (combination 2), it is possible to determine that a substrate equipped with the fuse 55 is replaced with a new service parts in a commercial market. In this case, the digital copying machine 1 sets a model by itself. Specifically, the fuse disconnecting unit 56 is activated to set the fuse 55 to be in the disconnected state, and the model-specific data is set and stored in the fuse 55, similarly to a case for setting a model in the intermediate sales point 120.

In other cases where pieces of the model-specific data do not indicate the same performance, if one of the settings in the main control unit 30 and the engine control unit 50 indicates the high-performance model even when the digital copying machine 1 sets the model-specific data by itself and the fuse 55 covered from outside is in the disconnected state thus indicating the low-performance model (combinations 3, 5, and 7), there is a possibility that a fraudulent operation is performed in a commercial market. In this case, an error processing is performed.

For the combinations 4 and 6, the model-specific data indicating the high-performance model is included and the state of the fuse 55 is high-performance model even when the model-specific data in one of the nonvolatile memories 34 and 54 indicates the low-performance model. Therefore, it is determined that an error has occurred, thus performing the error processing. A series of the above operations is performed when setting the model and after setting the model.

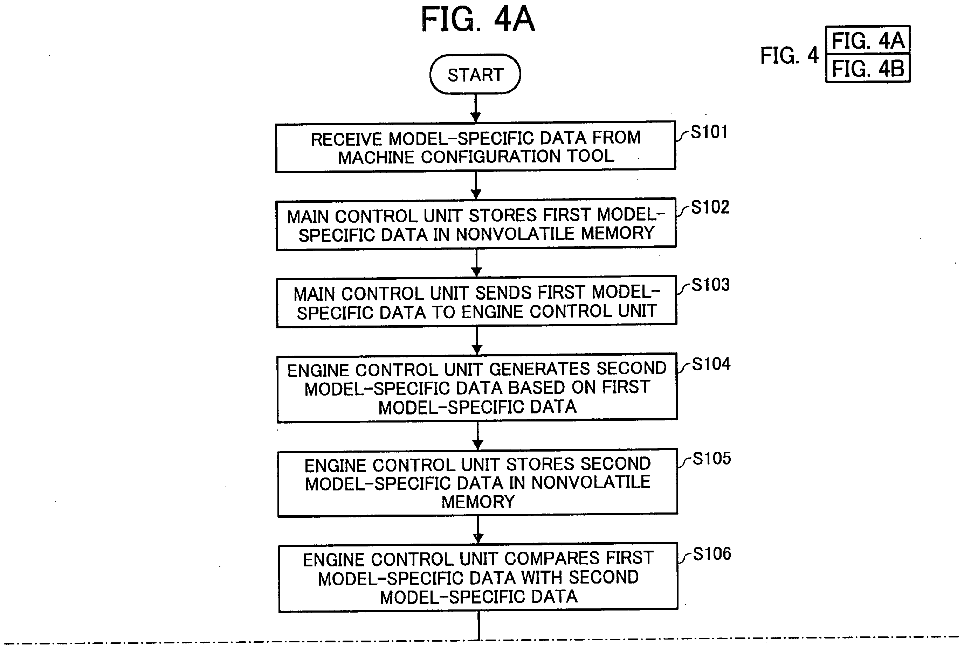

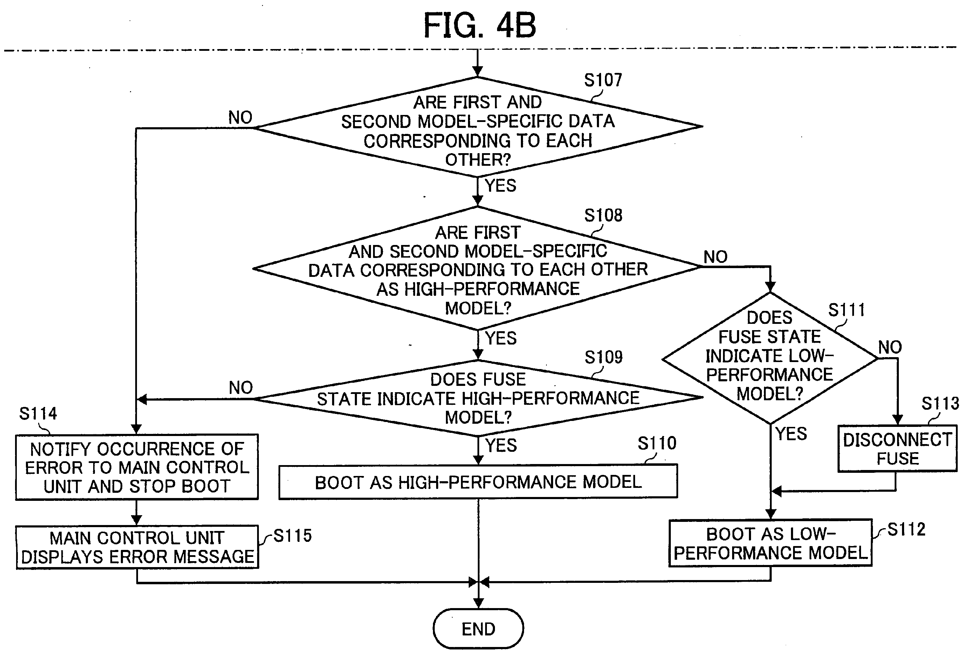

Fig. 4 is a flowchart for explaining an operation performed, when setting a model, by the digital copying machine 1. As shown in Fig. 4, upon receiving the model-specific data from the machine configuration tool 5 (step S101), the main control unit 30 stores the first model-specific data in the nonvolatile memory 34 (step S102). At the same time, the main control unit 30 sends the first model-specific data to the engine control unit 50 (step S103) .

The CPU 51 of the engine control unit 50 generates the second model-specific data, based on the received first model-specific data, for determining the performance of the digital copying machine 1 (step S104), and stores the second model-specific data in the nonvolatile memory 54 (step S105). The CPU 51 of the engine control unit 50 compares the model-specific data stored in each of the nonvolatile memories 34 and 54 with each other (step S106).

The digital copying machine 1 determines whether the two pieces of the model-specific data indicate the same performance (step S107). When determined that the two pieces of the model-specific data indicate the same performance, because the case corresponds to one of the combinations 1, 2, 7, and 8 shown in Fig. 3, the model-specific data is determined whether the model-specific data indicate the high-performance model at step S108. When determined that the two pieces of the model-specific data are indicate the high-performance model at step S108, it is determined whether the state of the fuse 55 indicates the high-performance model (step S109). When it is determined that the state of the fuse 55 indicates the high-performance model, the digital copying machine 1 is booted as the high-performance model (step S110).

On the other hand, when it is determined that the two pieces of the model-specific data indicate the low-performance model at step S108, it is determined whether the state of the fuse 55 indicates the low-performance model (step S111). When it is determined that the state of the fuse 55 indicates the low-performance model, the digital copying machine 1 is booted as the low-performance model (step S112). When it is determined that the stat of the fuse 55 does not indicate the low-performance model at step Sill, because the case corresponds to the combination 2 shown in Fig. 3, the digital copying machine 1 itself disconnects the fuse 55 by the fuse disconnecting unit 56 (step S113), and performs a normal boot as the low-performance model (step S112).

When determined that the two pieces of the model-specific data do not indicate the same performance at step S107 (combinations 3 to 6), or when determined that the state of the fuse 55 does not indicate the high-performance model at step S109 although it is determined that the two pieces of the model-specific data indicate the high-performance model at step S108 (combination 7), it is determined that fraudulent modification is performed in the commercial market or an error is occurring. Accordingly, the error processing is performed. In other words, an occurrence of the error is notified to the CPU 31 of the main control unit 30 and boot is suspended (step S114). The CPU 31 of the main control unit 30 displays an error message on a display unit (not shown) to notify the occurrence of the error to a user (step S115).

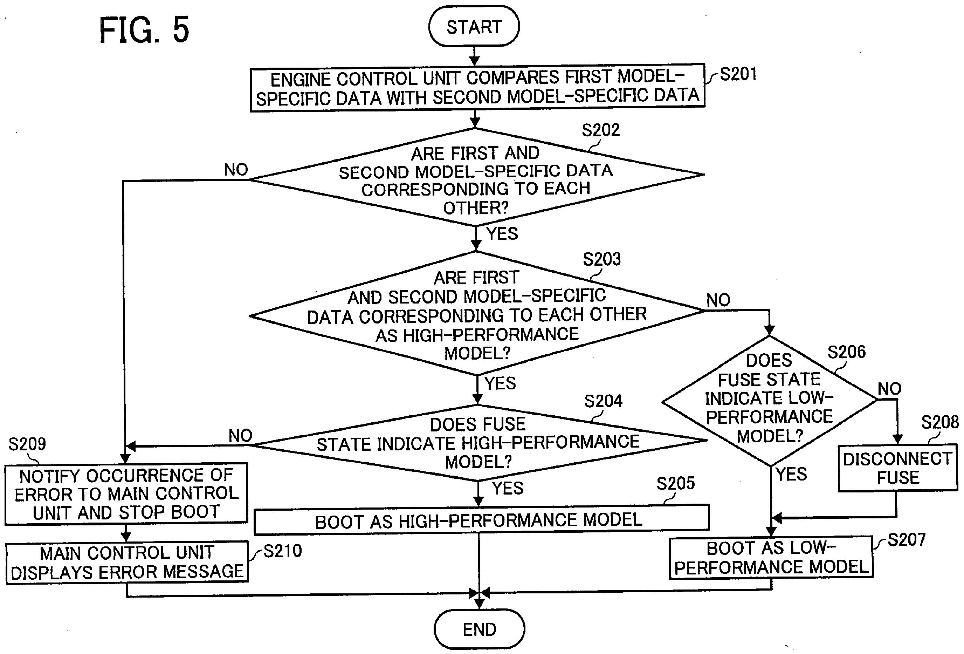

Fig. 5 is a flowchart for explaining an operation performed, after setting a model, by the digital copying machine 1. The CPU 51 of the engine control unit 50 compares the model-specific data stored in each of the nonvolatile memories 34 and 54 with each other (step S201).

The digital copying machine 1 determines whether the two pieces of the model-specific data indicate the same performance (step S202). When determined that the two pieces of the model-specific data indicate the same performance, because the case corresponds to one of the combinations 1, 2, 7, and 8 shown in Fig. 3, it is determined whether the model-specific data indicate the high-performance model at step S203. When determined that the two pieces of the model-specific data indicate the high-performance model, it is determined whether the state of the fuse 55 indicates the high-performance model (step S204). When it is determined that the state of the fuse 55 indicates the high-performance model, the digital copying machine is booted as the high-performance model (step S205).

When determined that the two pieces of the model-specific data indicate the low-performance model at step S203, it is determined whether the state of the fuse 55 indicates the low-performance model (step S206). When it is determined that the state of the fuse 55 indicates the low-performance model, the digital copying machine 1 is booted as the low-performance model (step S207). On the other hand, when it is determined that the state of the fuse 55 does not indicate the low-performance model at step S206, the case corresponds to the combination 2 shown in Fig. 3, so that the digital copying machine 1 itself disconnects the fuse 55 by the fuse disconnecting unit 56 (step S208), and performs a normal boot as the low-performance model (step S207).

When it is determined that the two pieces of the model-specific data do not indicate the same performance at step S202 (combinations 3 to 6), or when determined that the state of the fuse 55 does not indicate the high-performance model at step S204 although it is determined that the two pieces of the model-specific data indicate the high-performance model at step S203 (combination 7), it is determined that fraudulent modification is performed in the commercial market or an error is occurring. Accordingly, the error processing is performed. In other words, an occurrence of the error is notified to the CPU 31 of the main control unit 30 and boot is suspended (step S209). The CPU 31 of the main control unit 30 displays an error message on a display unit (not shown) to notify the occurrence of the error to a user (step S210).

As described above, according to the first embodiment, the same operations are performed when setting the model (see steps S106 to S115 in connection with Fig. 4) and after setting the model (see steps S201 to S210 in connection with Fig. 5), based on the combinations of the two pieces of the model-specific data and the state of the fuse 55 as shown in Fig. 3, and the digital copying machine 1 itself performs the model setting (see steps Sill to S113 shown in Fig. 4 and steps S206 to 208 shown in Fig. 5). Furthermore, the digital copying machine 1 includes the fuse 55 having the irreversibility, in addition to the nonvolatile memory 34 of the main control unit 30 and the nonvolatile memory 54 of the engine control unit 50.

Accordingly, by setting a post-transition state (a state after disconnection) of the fuse 55 as the low-performance model, which makes a transition from an initial state (a state before disconnection), when the fuse 55 makes a transition to the post-transition state indicating the low-performance model (the state after disconnection), the fuse 55 can hardly make a transition back to a state of the high-performance model (the state before disconnection). Therefore, it is possible to assuredly prevent a fraudulent modification, in which the low-performance model is modified to serve as the high-performance model.

Furthermore, the digital copying machine 1 performs a disconnection of the fuse 55 based on a determination performed by itself, and determines a validity of the disconnection by checking a state of the fuse 55. Therefore, security can be highly assured even when the model-specific data is copied and installed in the digital copying machine 1, because the digital copying machine 1 determines a validity based on the state of the fuse 55.

Moreover, the digital copying machine 1 performs a disconnection of the fuse 55 based on a determination performed by itself, and determines a validity of the disconnection by checking a state of the fuse 55. Therefore, it is possible to standardize service parts (e.g., the fuse before being disconnected) of a substrate on which a fuse is installed, so that security can be highly assured.

A configuration of a digital copying machine according to a second embodiment of the present invention is described with reference to Fig. 1. The CPU 51 of the engine control unit 50 determines whether the digital copying machine 1 serves as the high-performance model or the low-performance model, based on the model-specific data stored in each of the nonvolatile memory 34 of the main control unit 30 and the nonvolatile memory 54 of the engine control unit 50. When the digital copying machine 1 is determined to serve as the high-performance model, the fuse 55 continues to be in a connected state without operating the fuse disconnecting unit 56. On the other hand, when the digital copying machine 1 is determined to serve as the low-performance model, the fuse disconnecting unit 56 is activated to disconnect the fuse 55 to set the state of the fuse 55 to be the low-performance model.

At this state, according to the second embodiment, the fuse-state detecting unit 57 checks whether the fuse 55 has been actually disconnected. When the fuse 55 is actually disconnected, the digital copying machine 1 is booted as the low-performance model. When the disconnection of the fuse 55 is failed, an error processing is performed.

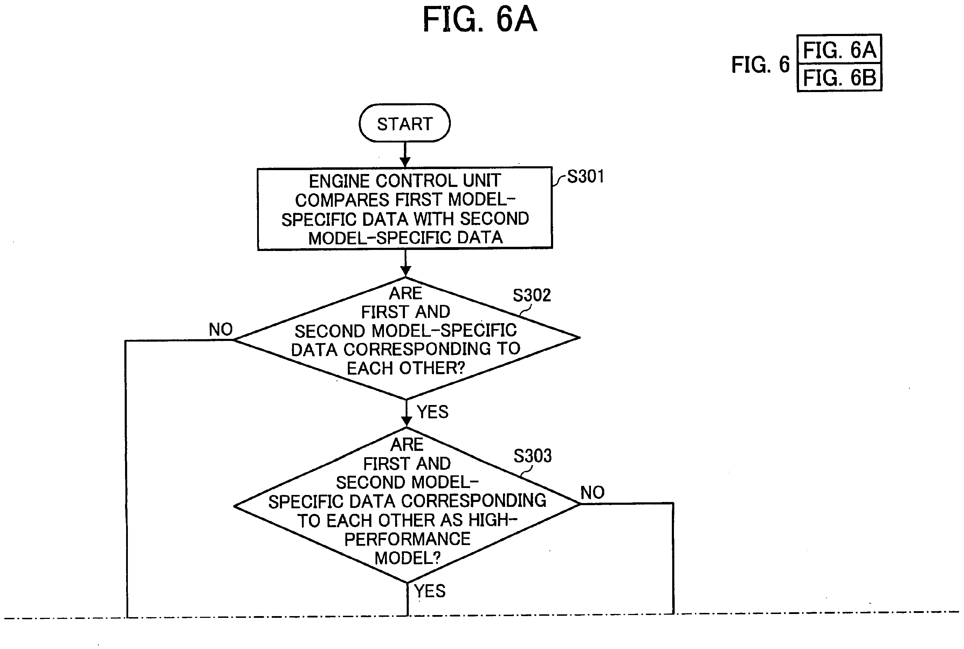

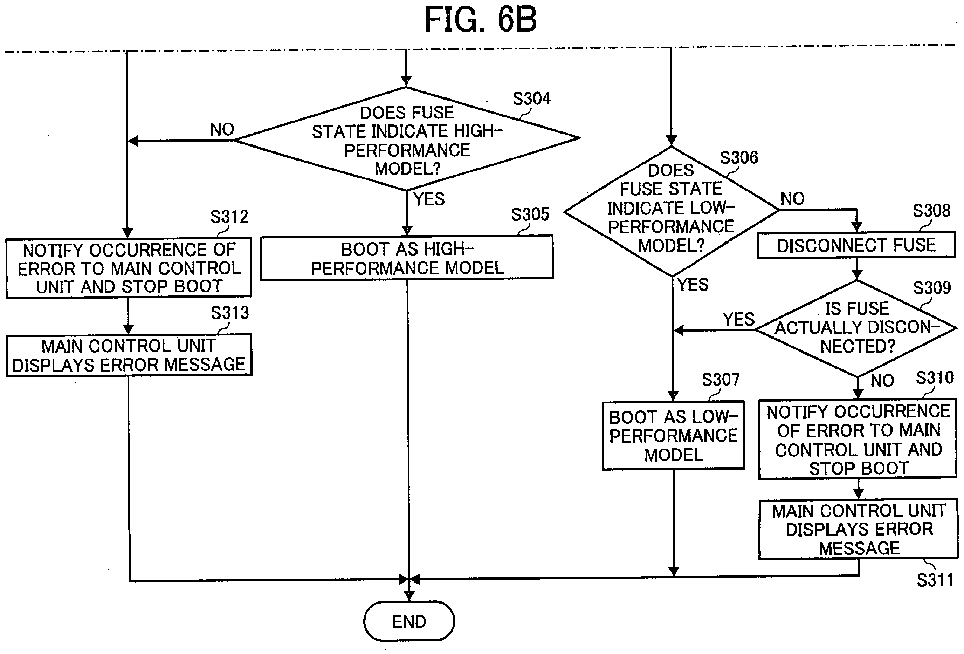

Fig. 6 is a flowchart for explaining an operation performed, after setting a model, by the digital copying machine 1. As shown in Fig. 6, process procedures described at steps S309 to 311 are added to steps described in connection with Fig. 5, in which an operation is performed after setting the model, according to the first embodiment. The process procedures described in connection with steps S301 to S308, S312, and S313 are the same as those at steps S201 to S208, S209, and S210 described in connection with Fig. 5, and therefore, explanations thereof are omitted.

At step S308 shown in Fig. 6, the CPU 51 of the engine control unit 50 disconnects the fuse 55 using the fuse disconnecting unit 56 when pieces of the model-specific data corresponds to the combination 2 shown in Fig. 3. However, if the fuse 55 cannot be disconnected due to some reasons even when the fuse 55 is blown out using the fuse disconnecting unit 56, the state remains in the high-performance model without being changed to the low-performance model.

In this case, the CPU 51 of the engine control unit 50 checks whether the fuse 55 is actually disconnected, by the fuse-state detecting unit 57 (step S309). When it is confirmed that the fuse 55 is actually disconnected, the process control proceeds to step S307 to boot the digital copying machine 1 as the low-performance model. On the other hand, when a disconnection of the fuse 55 is not detected, an occurrence of an error is notified to the main control unit 30 to suspend boot (step S310).

The CPU 31 of the main control unit 30 displays an error message on a display unit (not shown) (step S311) to notify the occurrence of an error to a user.

According to the second embodiment, it is checked whether the fuse 55 is surely disconnected after the fuse 55 is blown out, so that it is possible to prevent a fraudulent use as the high-performance model by displaying an error, even when the fuse is not actually disconnected.

In the digital copying machine 1 according to a third embodiment of the present invention, the fuse 55 as an irreversible element is covered by a body. In this case, it is difficult to determine whether the fuse is in the disconnected state or in the connected state when viewed from an outside, so that data can be concealed and a fraudulent modification can be prevented. Various configurations can be applied for covering the fuse 55 by a body, i.e., circumferences of the fuse 55 is covered in plates, or the fuse 55 can be integrally molded by resin. In the configurations, it is preferable to cover the fuse 55 in such a manner that the fuse 55 is kept concealed and covered without being easily exposed.

Furthermore, by installing the fuse 55 covered by the body on the substrate, the substrate including the fuse 55 can be standardized as a service parts, data can be concealed, and a fraudulent modification can be prevented. As a result, a security is highly assured.

Moreover, a state of the fuse 55, which is covered by the body and attached to the substrate, is set to be in the connected state. Therefore, the substrate with the fuse 55 equipped can be standardized as a service parts, and a security can be highly assured.

As described above, according to the third embodiment, the fuse 55 is covered by the body, the fuse 55 covered by the body is attached to the substrate, and the state of the fuse 55 attached to the substrate is set to be in the connected state. Therefore, data can be concealed, a fraudulent modification can be prevented, and the substrate including the fuse 55 can be standardized as a service parts. As a result, the security is highly assured.

The digital copying machine 1 according to a fourth embodiment of the present invention is configured in such a manner that, when a substrate to which the fuse 55 is attached is replaced with a new substrate, the state of the model-specific data is to be in the combination 2 shown in Fig. 3 at the time of next power ON. In this case, the digital copying machine 1 sets the model by itself by determining that the substrate with the fuse 55 has been replaced, based on a result of a retrieval of the model-specific data.

A flowchart for explaining an operation according to the fourth embodiment is the same as those shown in Figs. 5 and 6, in which the operation performed after setting the model is described according to the first and the second embodiments. In other words, when the digital copying machine 1 determines that the substrate with the fuse 55 has been replaced, based on a result of a retrieval of the model-specific data, the state of the model-specific data is to be in the combination 2 shown in Fig. 3 at the time of next power ON.

Accordingly, in the flowchart shown in Fig. 5, when determined to be in the combination 2 at step S206, the fuse 55 is disconnected (step S208) and the digital copying machine 1 is booted as the low-performance model (step S207).

In the flowchart shown in Fig. 6, when determined to be in the combination 2 at step S306, the fuse 55 is disconnected (step S308), and the fuse-state detecting unit 57 checks whether the fuse 55 is actually disconnected (step S309). When a disconnection of the fuse 55 is detected, the digital copying machine 1 is booted as the low-performance model (step S307). On the other hand, when the disconnection of the fuse 55 is not detected, an occurrence of an error is notified to the CPU 31 of the main control unit 30 to suspend boot (step S310). Subsequently, the CPU 31 of the main control unit 30 displays an error message on a display unit (not shown) (step S311) to notify the occurrence of an error to a user.

As described above, according to the fourth embodiment, when it is determined that the substrate with the fuse is replaced, the digital copying machine sets the model by itself and performs a normal boot as the low-performance model, by determining that the state is in the combination 2 shown in Fig. 3. Therefore, a fraudulent modification can be prevented. In other words, the digital copying machine itself automatically performs a boot as the low-performance model even when the substrate is replaced, for fraudulently modifying the low-performance model to be the high-performance model, with a new substrate on which a connected fuse is installed. Thus, a fraudulent use can be prevented.

A configuration of a digital copying machine according to a fifth embodiment of the present invention is described with reference to Fig. 1. The CPU 51 of the engine control unit 50 determines whether the digital copying machine 1 serves as the high-performance model or the low-performance model, based on the model-specific data stored in each of the nonvolatile memory 34 of the main control unit 30 and the nonvolatile memory 54 of the engine control unit 50. When the CPU 51 determines that the digital copying machine 1 serves as the high-performance model, the fuse 55 is kept in the connected state without operating the fuse disconnecting unit 56. On the other hand, when the CPU 51 determines that the digital copying machine 1 serves as the low-performance model, the fuse disconnecting unit 56 is activated to disconnect the fuse 55 to set the state of the fuse 55 to be in the low-performance model.

The digital copying machine 1 according to the fifth embodiment is configured in such a manner that the fuse-state detecting unit 57 checks whether the fuse 55 is actually disconnected when disconnecting the fuse 55. Accordingly, the digital copying machine is booted as the low-performance model when the fuse 55 is actually disconnected, while a retry is performed when the fuse 55 is not disconnected. In this case, an upper limit of the number of retries is determined, so that, when the fuse 55 cannot be disconnected after performing a retry for a predetermined number of times, the digital copying machine 1 determines that an error is occurring in the fuse 55, and suspends performing the retry to prevent the digital copying machine 1 from performing an abnormal operation caused by the retry performed for more than the predetermined number of times. Because the digital copying machine 1 is set as the low-performance model by the model setting, an occurrence of a retry number error is stored in the nonvolatile memory 54 of the engine control unit 50, for not repeating a process of disconnecting the fuse 55 at the time of next power ON. In this case, a programming is performed in the digital copying machine so that the digital copying machine serves as the low-performance model regardless of the model-specific data stored in the nonvolatile memory and the state of the fuse 55.

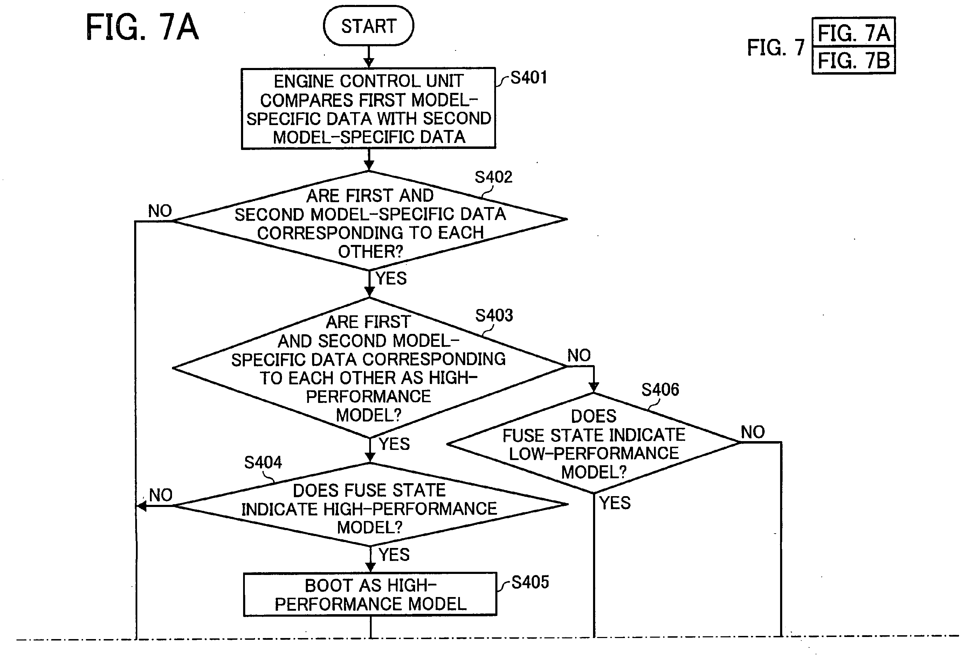

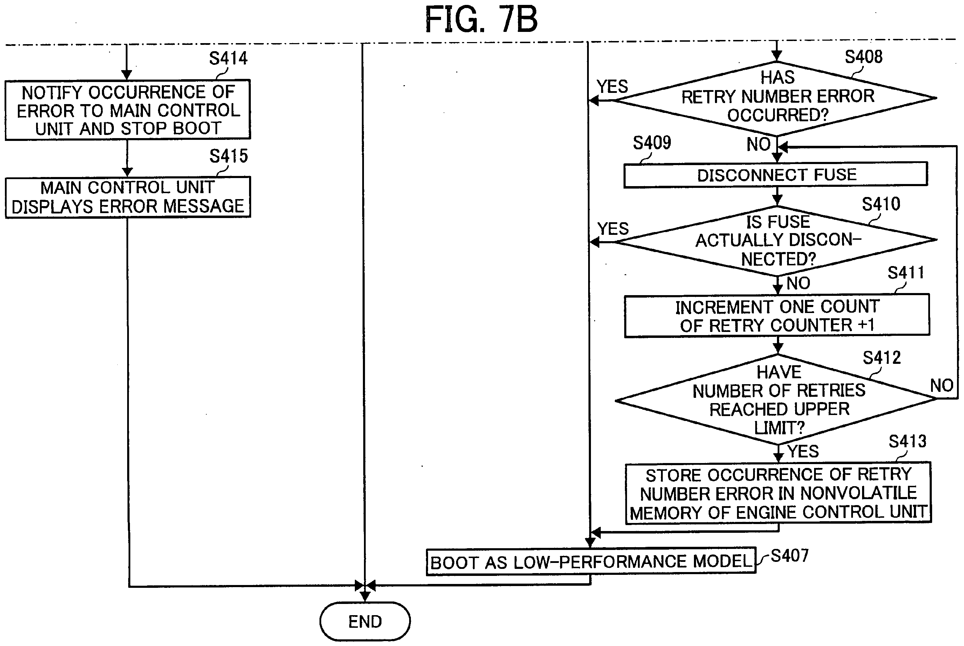

Fig. 7 is a flowchart for explaining an operation performed, after setting a model, by the digital copying machine 1 according to the fifth embodiment of the present invention. As shown in Fig. 7, process procedures described at steps S408 to S413 are added to steps described in connection with Fig. 5, in which the operation performed after setting the model is described according to the first embodiment. The process procedures described in connection with steps S401 to S407, S414, and S415 described in connection with Fig. 7 are the same as those at steps S201 to S207, S209, and S210 described in connection with Fig. 5, and therefore, explanations thereof are omitted.

At step S406 shown in Fig. 7, when the state of the model-specific data is in the combination 2 shown in Fig. 3, the process control proceeds to step S408, to determine whether the retry number error has occurred. A log of the retry number error is stored in the nonvolatile memory 54 by the CPU 51 of the engine control unit 50 every time the retry number error occurs, so that the occurrence of the retry number error can be checked by the CPU 51 by accessing the nonvolatile memory 54.

When it is determined that the retry number error has occurred at step S408, the process control proceeds to step S407 to boot the digital copying machine as the low-performance model. When the retry number error has not occurred, the fuse 55 is disconnected (step S409).

After the fuse 55 is disconnected, the CPU 51 of the engine control unit 50 causes the fuse-state detecting unit 57 to check whether the fuse 55 is actually disconnected (step S410). When the fuse 55 is actually disconnected, the process control proceeds to step S407 to boot the digital copying machine as the low-performance model. When the fuse 55 is not disconnected, the process control proceeds to step S411 to increment one count (+1) of a retry counter (not shown) and determines whether the number of the retries reaches the upper limit (step S412).

When the number of the retries does not reach the upper limit, the process control returns to step S409 to retry a disconnection of the fuse 55. On the other hand, when the number of the retries reaches the upper limit, the retry is suspended because the abnormal operation is possibly caused to the digital copying machine 1 by performing an extra retry. At step S413, the occurrence of the retry number error is stored in the nonvolatile memory 54 of the engine control unit 50.

As described above, according to the fifth embodiment, an existence of the log of the retry number error in disconnecting the fuse is detected before the fuse 55 is blown out. When an occurrence of the retry number is not detected, the process of disconnecting the fuse is performed until the number of the retries reaches the upper limit. When the number of the retries reaches the upper limit, the log as the retry number error is stored in the nonvolatile memory 54. Accordingly, it is possible to effectively repeat the process of disconnecting the fuse as long as any difficulties occur. When the retry number error has occurred, retry is not needed because there is a possibility that a failure is occurring in the digital copying machine itself. When the retry number error has not occurred, it is necessary to perform the retry for setting the model, within the number of times that does not cause problems to the digital copying machine.

The model-performance determining apparatus of the present invention is installed in a digital copying machine or a multifunction product, with which a single model can serve a plurality of model performances. Therefore, a model of the digital copying machine or the multifunction product can be applicable for a required model by performing a model setting corresponding to a required destination or a required model performance. As a result, it is possible to reduce a manufacturing cost or an inventory cost caused by an increase of the number of the models.

Furthermore, the model-performance determining apparatus of the present invention can serve a plurality of the model performances by a single model. In this case, a change from the high-performance model to the low-performance model can be performed using the irreversible unit having irreversibility, such as a fuse, while the change from the low-performance model to the high-performance model cannot be performed. Therefore, a fraudulent modification can be prevented.

Moreover, the model-performance determining apparatus of the present invention is configured in such a manner that the fuse as the irreversible element is covered by the body, so that data can be concealed and the fraudulent modification can be prevented in a more efficient manner. In addition, the machine automatically performs a model setting to be the low-performance model based on a determination performed by itself, or displays an error, when the fuse or the substrate on which the fuse is installed is fraudulently changed to fraudulently change the model performance from the low-performance model to the high-performance model. Therefore, it is possible to prevent the fraudulent modification.

Although two types of the model performances, i.e., the high-performance model and the low-performance model, are provided for a determination according to the embodiments, it is possible to select one model from three or more different types of the model performances using a plurality of the irreversible elements.

Although the embodiments of the present invention are described above, conditions or requirements described in the embodiments are examples, and therefore, the present invention is not thus limited. For example, although the fuse is described as an example of the irreversible element having irreversibility according to the embodiments, it is possible to realize the same configuration by a combination of a gear, a clutch, and a sensor. Accordingly, any modifications can be appropriately applicable depending on a type of an application.

As described above, according to an aspect of the present invention, an irreversible unit that realizes an irreversibility is included, which can make a transition from a first state to a second state and cannot make a transition from the second state to the first state. A comparing unit compares first model-specific data stored in a first storing unit for determining a performance of a target machine with second model-specific data stored in a second storing unit for determining the performance of the target machine based on the first model-specific data. A setting unit sets the state of the irreversible unit based on a comparison result. A performance determining unit determines the performance of the target machine based on the first model-specific data, the second model-specific data, and the state of the irreversible unit. As described above, because the model-performance determining apparatus can set the model performance of the target machine, an extra operation performed by a service provider or the like can be omitted, preventing a fraudulent modification.

For example, by using the irreversible unit, such as a fuse, the target machine cannot be modified to the high-performance model after the performance of the target model is determined to serve as the low-performance model by disconnecting the fuse. Accordingly, even if the first and the second model-specific data respectively stored in the first and the second storing units are dumped, physically disconnected fuse is hardly connected again. Therefore, it is possible to prevent a fraudulent modification. Furthermore, if a substrate including the irreversible unit is replaced to fraudulently modify the target machine to serve as the high-performance model, a performance maintaining unit forcibly disconnects the fuse based on the first and the second model-specific data to keep the state of the target machine in the low-performance model. Therefore, a fraudulent modification can be prevented.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A model-performance determining device for setting a model performance of a target machine (1) being an electronic apparatus for which the model performance is to be set and which includes the model-performance determining device, the device comprising:
a first storing unit (34) that stores therein first model-specific data defining a performance of the target machine (1); and
an irreversible unit (55) that realizes an irreversible state in which a transition is possible from a second state to a first state, while a transition is not possible from the first state to the second state; **characterized by**
a generating unit (51) that generates second model-specific data defining a performance of the target machine (1) based on the first model-specific data;
a second storing unit (54) that stores therein the second model-specific data;
a comparing unit (51) that compares the first model-specific data with the second model-specific data;
a setting unit (56) that sets a state of the irreversible unit (55) based on a result of comparison by the comparing unit (51); and
a performance determining unit (51) that determines the performance of the target machine (1) based on the first model-specific data, the second model-specific data, and the state of the irreversible unit (55).

2. The device according to claim 1, further comprising a checking unit (57) that checks the state of the irreversible unit (55) when the result of comparison satisfies a predetermined condition.

3. The device according to claim 2, further comprising a performance maintaining unit (56) that maintains the performance of the target machine (1) by making a transition of the state of the irreversible unit (55) in the second state to the first state when the predetermined condition is satisfied.

4. The device according to claim 1, wherein
the irreversible unit (55) includes
a fuse (55) that can be blown out, and
a disconnecting unit (56) that disconnects the fuse (55), and
the setting unit (56) sets a state of the fuse (55) to either one of a disconnected state and a connected state using the disconnecting unit (56).

5. The device according to claim 3, wherein
the irreversible unit (55) includes
a fuse (55) that can be blown out, and
a disconnecting unit (56) that disconnects the fuse (55), and
the performance maintaining unit (56) maintains the performance of the target machine (1) by making a transition of a state of the fuse (55) in the second state to the first state using the disconnecting unit (56).

6. The device according to claim 1, wherein when the result of comparison indicates that the first model-specific data and the second model-specific data are different, the performance determining unit (51) performs an error processing indicating that the performance of the target machine (1) cannot be determined.

7. The device according to claim 5, wherein when the fuse (55) in the second state cannot make a transition to the first state even after performing a disconnecting processing to disconnect the fuse (55) in the second state using the disconnecting unit (56), the performance determining unit (51) performs an error processing indicating that the performance of the target machine (1) cannot be determined.

8. The device according to claim 5, wherein when the fuse (55) in the second state cannot make a transition to the first state even after performing a predetermined times of disconnecting processings to disconnect the fuse (55) in the second state using the disconnecting unit (56), the performance determining unit (51) maintains the performance of the target machine (1) to a predetermined performance.

9. The device according to any one of claims 4, 5, 7, and 8, wherein the fuse (55) is entirely covered by a casing.

10. An image forming apparatus (1) comprising the device according to any one of claims 1 to 9, the image forming apparatus (1) being the target machine.

## Patentansprüche

1. Modellleistungsbestimmungseinrichtung zum Einstellen einer Modellleistung einer Zielmaschine (1), die eine elektronische Vorrichtung ist, für die die Modellleistung eingestellt werden soll, und die die Modelleistungsbestimmungseinrichtung enthält, wobei die Einrichtung Folgendes umfasst:
eine erste Speichereinheit (34), die darin erste modellspezifische Daten speichert, die eine Leistung der Zielmaschine (1) definieren; und
eine unumkehrbare Einheit (55), die einen unumkehrbaren Zustand realisiert, bei dem ein Übergang von einem zweiten Zustand in einen ersten Zustand möglich ist, während ein Übergang vom ersten Zustand in den zweiten Zustand nicht möglich ist; **gekennzeichnet durch**
eine Erzeugungseinheit (51), die auf der Grundlage der ersten modellspezifischen Daten zweite modellspezifische Daten erzeugt, die eine Leistung der Zielmaschine (1) definieren;
eine zweite Speichereinheit (54), die darin die zweiten modellspezifischen Daten speichert;
eine Vergleichseinheit (51), die die ersten modellspezifischen Daten mit den zweiten modellspezifischen Daten vergleicht;
ein Einstelleinheit (56), die auf der Grundlage eines Ergebnisses des Vergleichs durch die Vergleichseinheit (51) einen Zustand der unumkehrbaren Einheit (55) einstellt; und
eine Leistungsbestimmungseinheit (51), die auf der Grundlage der ersten modellspezifischen Daten, der zweiten modellspezifischen Daten und des Zustands der unumkehrbaren Einheit (55) die Leistung der Zielmaschine (1) bestimmt.

2. Einrichtung nach Anspruch 1, die ferner eine Prüfeinheit (57) umfasst, die den Zustand der unumkehrbaren Einheit (55) prüft, wenn das Ergebnis des Vergleichs eine vorgegebene Bedingung erfüllt.

3. Einrichtung nach Anspruch 2, die ferner eine Leistungsaufrechterhaltungseinheit (56) umfasst, die die Leistung der Zielmaschine (1) aufrechterhält, indem sie einen Übergang des Zustands der unumkehrbaren Einheit (55) im zweiten Zustand in den ersten Zustand durchführt, wenn die vorgegebene Bedingung erfüllt ist.

4. Einrichtung nach Anspruch 1, wobei
die unumkehrbare Einheit (55) Folgendes enthält:
eine Sicherung (55), die durchgebrannt werden kann, und
eine Trenneinheit (56), die die Sicherung (55) trennt, und
die Einstelleinheit (56) unter Verwendung der Trenneinheit (56) einen Zustand der Sicherung (55) entweder auf einen getrennten Zustand oder einen verbundenen Zustand einstellt.

5. Einrichtung nach Anspruch 3, wobei
die unumkehrbare Einheit (55) Folgendes enthält:
eine Sicherung (55), die durchgebrannt werden kann, und
eine Trenneinheit (56), die die Sicherung (55) trennt, und
die Leistungsaufrechterhaltungseinheit (56) die Leistung der Zielmaschine (1) aufrechterhält, indem sie unter Verwendung der Trenneinheit (56) einen Übergang von einem Zustand der Sicherung (55) im zweiten Zustand in den ersten Zustand durchführt.

6. Einrichtung nach Anspruch 1, wobei dann, wenn das Ergebnis des Vergleichs angibt, dass die ersten modellspezifischen Daten und die zweiten modellspezifischen Daten verschieden sind, die Leistungsbestimmungseinheit (51) eine Fehlerverarbeitung durchführt, die angibt, dass die Leistung der Zielmaschine (1) nicht bestimmt werden kann.

7. Einrichtung nach Anspruch 5, wobei dann, wenn die Sicherung (55) im zweiten Zustand selbst nach dem Durchführen einer Trennungsverarbeitung unter Verwendung der Trenneinheit (56), um die Sicherung (55) im zweiten Zustand zu trennen, keinen Übergang in den ersten Zustand durchführen kann, die Leistungsbestimmungseinheit (51) eine Fehlerverarbeitung durchführt, die angibt, dass die Leistung der Zielmaschine (1) nicht bestimmt werden kann.

8. Einrichtung nach Anspruch 5, wobei dann, wenn die Sicherung (55) im zweiten Zustand selbst nach dem Durchführen von vorgegebenen Wiederholungen von Trennungsverarbeitungen unter Verwendung der Trenneinheit (56), um die Sicherung (55) im zweiten Zustand zu trennen, keinen Übergang in den ersten Zustand durchführen kann, die Leistungsbestimmungseinheit (51) die Leistung der Zielmaschine (1) auf einer vorgegebenen Leistung aufrechterhält.

9. Einrichtung nach einem der Ansprüche 4, 5, 7, und 8, wobei die Sicherung (55) durch ein Gehäuse vollständig abgedeckt ist.

10. Bilderzeugungsvorrichtung (1), die die Einrichtung nach einem der Ansprüche 1 bis 9 umfasst, wobei die Bilderzeugungsvorrichtung (1) die Zielmaschine ist.

## Revendications

1. Dispositif de détermination de la performance de modèle destiné à définir la performance de modèle d'une machine cible (1) étant un appareil électrique pour lequel la performance de modèle doit être définie et qui comprend le dispositif de détermination de la performance de modèle, le dispositif comprenant :
une première unité de stockage (34) qui stocke à l'intérieur des premières données spécifiques au modèle définissant une performance de la machine cible (1) ; et
une unité irréversible (55) qui produit un état irréversible dans lequel une transition est possible d'un deuxième état à un premier état, tandis qu'une transition n'est pas possible du premier état au deuxième état ; **caractérisé par**
une unité de génération (51) qui génère des deuxièmes données spécifiques au modèle définissant une performance de la machine cible (1) en fonction des premières données spécifiques au modèle ;
une deuxième unité de stockage (54) qui stocke à l'intérieur les deuxièmes données spécifiques au modèle ;
une unité de comparaison (51) qui compare les premières données spécifiques au modèle aux deuxièmes données spécifiques au modèle ;
une unité de définition (56) qui définit un état de l'unité irréversible (55) en fonction d'un résultat de comparaison par l'unité de comparaison (51) ; et
une unité de détermination de performance (51) qui détermine la performance de la machine cible (1) en fonction des premières données spécifiques au modèle, des deuxièmes données spécifiques au modèle et de l'état de l'unité irréversible (55).

2. Dispositif selon la revendication 1, comprenant en outre une unité de vérification (57) qui vérifie l'état de l'unité irréversible (55) lorsque le résultat de comparaison satisfait une condition prédéterminée.

3. Dispositif selon la revendication 2, comprenant en outre une unité de maintien de performance (56) qui maintient la performance de la machine cible (1) en effectuant une transition de l'état de l'unité irréversible (55) dans le deuxième état au premier état où la condition prédéterminée est satisfaite.

4. Dispositif selon la revendication 1, dans lequel
l'unité irréversible (55) comprend
un fusible (55) qui peut être explosé, et
une unité de déconnexion (56) qui déconnecte le fusible (55), et
l'unité de définition (56) définit un état du fusible (55) à un état déconnecté ou un état connecté au moyen de l'unité de déconnexion (56).

5. Dispositif selon la revendication 3, dans lequel
l'unité irréversible (55) comprend
un fusible (55) qui peut être explosé, et
une unité de déconnexion (56) qui déconnecte le fusible (55), et
l'unité de maintien de performance (56) qui maintient la performance de la machine cible (1) en effectuant une transition d'un état du fusible (55) dans le deuxième état au premier état au moyen de l'unité de déconnexion (56).

6. Dispositif selon la revendication 1, dans lequel lorsque le résultat de comparaison indique que les premières données spécifiques au modèle et les deuxièmes données spécifiques au modèle sont différentes, l'unité de détermination de performance (51) effectue un traitement d'erreur indiquant que la performance de la machine cible (1) ne peut pas être déterminée.

7. Dispositif selon la revendication 5, dans lequel lorsque le fusible (55) dans le deuxième état ne peut pas effectuer une transition vers le premier état même après avoir effectué un traitement de déconnexion pour déconnecter le fusible (55) dans le deuxième état au moyen de l'unité de déconnexion (56), l'unité de détermination de performance (51) effectue un traitement d'erreur indiquant que la performance de la machine cible (1) ne peut pas être déterminée.

8. Dispositif selon la revendication 5, dans lequel lorsque le fusible (55) dans le deuxième état ne peut pas effectuer une transition vers le premier état même après avoir effectué des traitements de déconnexion un nombre prédéterminé de fois pour déconnecter le fusible (55) dans le deuxième état au moyen de l'unité de déconnexion (56), l'unité de détermination de performance (51) maintient la performance de la machine cible (1) à une performance prédéterminée.

9. Dispositif selon l'une quelconque des revendications 4, 5, 7 et 8, dans lequel le fusible (55) est entièrement recouvert d'un boîtier.

10. Appareil de formation d'image (1) comprenant le dispositif selon l'une quelconque des revendications 1 à 9, l'appareil de formation d'image (1) étant la machine cible.
